(19) Europäisches Patentamt
European Patent Office
Office européen des brevets

(11) **EP 4 471 724 A1**

(12) **EUROPEAN PATENT APPLICATION**

(43) Date of publication:
**04.12.2024 Bulletin 2024/49**

(21) Application number: **24177195.5**

(22) Date of filing: **22.05.2024**

(51) International Patent Classification (IPC):
**G06T 13/40** (2011.01)    **G06T 19/20** (2011.01)

(52) Cooperative Patent Classification (CPC):
**G06T 13/40; G06T 19/20;** G06T 2210/16;
G06T 2219/2021

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **02.06.2023 IN 202321038154**

(71) Applicant: **Tata Consultancy Services Limited
Maharashtra (IN)**

(72) Inventors:
• TIWARI, LOKENDER
**110 001 New Delhi (IN)**
• BHOWMICK, BROJESHWAR
**700160 Kolkata (IN)**
• SINHA, SANJANA
**700160 Kolkata (IN)**

(74) Representative: **Goddar, Heinz J.
Boehmert & Boehmert
Anwaltspartnerschaft mbB
Pettenkoferstrasse 22
80336 München (DE)**

(54) **METHOD AND SYSTEM FOR GENERIC GARMENT SIMULATION**

(57) State of the art approaches for 3D garment simulation approaches have the disadvantages that they 1) work on fixed garment type, 2) work on fixed body shapes, and 3) assume fixed garment topology. As a result, they do not offer a generic solution for garment simulation. Method and system disclosed herein use a combination of a body motion aware ARAP garment deformation and a Physics Enforcing Network (PEN), so as to generate garment simulations irrespective of garment type, body shapes, and garment topology, thus offering a generic solution.

FIG. 2

**Description**

CROSS-REFERENCE TO RELATED APPLICATIONS AND PRIORITY

The present application claims priority to Indian application no. 202321038154, filed on June 2, 2023.

TECHNICAL FIELD

The disclosure herein generally relates to garment simulation, and, more particularly, to a method and system for generic garment simulation.

BACKGROUND

Simulating 3D garments of varying types and sizes on 3D humans of arbitrary body shapes and poses is an important problem with direct applications in virtual try-on, garment authoring, garment catalog generation, etc. Although Physics-Based Simulation (PBS) approaches are preferable for accurate and realistic simulation of garments on 3D humans, they are computationally expensive and require expert intervention.

Recently, there has been a growing interest in data-driven learning-based simulation approaches as they reduce dependency on experts, and the time complexity of the simulation significantly. However, they have several limitations. Many of these methods 1) Work on fixed garment type: for instance, Physically Based Neural Simulation (PBNS), Self-supervised Neural dynamic Garments (SNUG), VBones, and DD3DG can simulate only the garment template/type which is used for training thereby requiring a new model for each garment type. 2) Work on fixed body shapes: VBones and PBNS work on the fixed body shape used for training. 3) Assume fixed garment topology: methods such as Deep-Draper, and TailorNet assume different sizes of garments to have the same number of vertices, hence cannot model loose and long garments such as skirts and dresses, which require more number of vertices to accurately represent the geometry (wrinkles and folds). The existing supervised methods are trained primarily by minimizing L2 distance w.r.t the PBS data. Minimizing such L2 distance jointly for multiple tight and loose garments tends to learn average displacement and compromise the physical plausibility of the deformation.

SUMMARY

Embodiments of the present disclosure present technological improvements as solutions to one or more of the above-mentioned technical problems recognized by the inventors in conventional systems. For example, in one embodiment, a processor implemented method is provided. The method includes obtaining, via one or more hardware processors, a garment template, an initial body pose, and a target body pose, as input data. Further, the garment template is aligned via the one or more hardware processors, on the target body pose, by estimating a body motion-aware as-rigid-as-possible (ARAP) garment deformation from the obtained input data. Further, a per-vertex displacement of the garment template is determined, via the one or more hardware processors, using a Physics Enforcing Network (PEN) based on the obtained input data and the estimated body motion-aware ARAP garment deformation. The PEN is trained using a restrain energy loss, wherein computing the restrain energy loss comprises: estimating absolute difference between edge length in the garment template and an associated edge length in a deformed garment template obtained using the motion-aware ARAP, for all of a plurality of edges; and computing the restrain energy loss based on the estimated absolute difference. Further, a final deformed garment template is generated via the one or more hardware processors, for the target pose, by adding the determined per-vertex displacement of the garment template to the estimated body motion-aware ARAP garment deformation.

In an embodiment of the method, estimating a body motion-aware as-rigid-as-possible (ARAP) garment deformation includes obtaining an index set of handle vertices of the garment template and associated displacement locations. Further, a displacement vector is computed for each handle vertex in the index set of handle vertices, with respect to position of the handle vertex indicated by the associated displacement location. Further, the following steps are performed for a pre-defined number of iterations: moving the handle vertices towards a final location in direction of the displacement vector, in a plurality of iterations; solving each non-handle vertex using ARAP; and solving collision of one or more of the handle vertices with body in the target body pose, comprising: identifying index of closest body vertex for each deformed non-handle vertex, and associated unit normal vector; identifying one or more collided vectors as projection of body to a garment vector onto the unit normal vector; and resolving identified collision by moving the one or more collided vectors towards a closest body vertex normal with a defined magnitude.

In another embodiment, determining the per-vertex displacement of the garment template using the Physics Enforcing Network (PEN) includes the following steps. Initially, one or more latent features of the garment template and the initial body pose are obtained from a geometry encoder. Further, the one or more latent features are concatenated with a plurality of parameters to obtain concatenated feature vector. Further, a node feature vector is obtained by processing the concatenated feature vector using a node encoder. Further, a relative position of edge end-vertices in the garment template and estimated garment deformation are determined. Further, the determined relative position of edge end-vertices are encoded into an edge feature vector using an edge encoder. Further, an encoded garment graph is constructed using the node feature vector and edge feature vector. Further, an updated encoded garment graph is obtained by iteratively performing a message passing algorithm on the encoded garment graph, wherein every node aggregates one or more features from associated one or more incident edges, wherein the aggregated one or more features are processed to update own features, and are broadcasted to one or more neighboring nodes, and every edge node updates own features by taking the features from associated end nodes. Further, the per-vertex displacement of the garment template is determined by passing the updated garment graph through a displacement decoder.

In another embodiment of the method, the plurality of parameters include a) a relative position of garment template vertex with respect to closest canonical pose body vertex, b) relative position of ARAP deformed garment template vertex with respect to closest target pose body vertex, c) a normal vector of the body vertex, d) a pin vertex indicator, e) a body motion vector, and f) a mass of the garment template vertex proportional to the area of associated faces.

In another embodiment of the method, the restrain loss is computed as:

$$l_{str} = \sum_{(i,j) \in E} \left( \frac{\varphi_{ij} - \mu_{fabric}}{\sigma_{fabric}} \right)^2,$$

where,

$\varphi_{ij}$ represents an absolute edge length difference, wherein the absolute edge length difference is absolute difference between length of an edge in the garment template and associated edge length in the deformed garment template, $\mu_{fabric}$ is fabric specific mean of the absolute edge length difference, and $\sigma_{fabric}$ is standard deviation of the absolute edge length difference.

In another embodiment of the method, the initial body pose is a 3D human body in the canonical body pose.

In yet another embodiment, a system is provided. The system includes one or more hardware processors, a communication interface, and a memory storing a plurality of instructions. The plurality of instructions when executed, cause the one or more hardware processors to obtain a garment template, an initial body pose, and a target body pose, as input data. Further, the garment template is aligned via the one or more hardware processors, on the target body pose, by estimating a body motion-aware as-rigid-as-possible (ARAP) garment deformation from the obtained input data. Further, a per-vertex displacement of the garment template is determined, via the one or more hardware processors, using a Physics Enforcing Network (PEN) based on the obtained input data and the estimated body motion-aware ARAP garment deformation. The PEN is trained using a restrain energy loss, wherein computing the restrain energy loss comprises: estimating absolute difference between edge length in the garment template and an associated edge length in a deformed garment template obtained using the motion-aware ARAP, for all of a plurality of edges; and computing the restrain energy loss based on the estimated absolute difference. Further, a final deformed garment template is generated via the one or more hardware processors, for the target pose, by adding the determined per-vertex displacement of the garment template to the estimated body motion-aware ARAP garment deformation.

In yet another embodiment of the system, the one or more hardware processors are configured to estimate a body motion-aware as-rigid-as-possible (ARAP) garment deformation by obtaining an index set of handle vertices of the garment template and associated displacement locations. Further, a displacement vector is computed for each handle vertex in the index set of handle vertices, with respect to position of the handle vertex indicated by the associated displacement location. Further, the following steps are performed for a pre-defined number of iterations: moving the handle vertices towards a final location in direction of the displacement vector, in a plurality of iterations; solving each non-handle vertex using ARAP; and solving collision of one or more of the handle vertices with body in the target body pose, comprising: identifying index of closest body vertex for each deformed non-handle vertex, and associated unit normal vector; identifying one or more collided vectors as projection of body to a garment vector onto the unit normal vector; and resolving identified collision by moving the one or more collided vectors towards a closest body vertex normal with a defined magnitude.

In yet another embodiment of the system, the one or more hardware processors are configured to determine the per-vertex displacement of the garment template using the Physics Enforcing Network (PEN), using the following steps. Initially, one or more latent features of the garment template and the initial body pose are obtained from a geometry encoder. Further, the one or more latent features are concatenated with a plurality of parameters to obtain concatenated feature vector. Further, a node feature vector is obtained by processing the concatenated feature vector using a node encoder. Further, a relative position of edge end-vertices in the garment template and estimated garment deformation are determined. Further, the determined relative position of edge end-vertices are encoded into an edge feature vector using an edge encoder. Further, an encoded garment graph is constructed using the node feature vector and edge feature vector. Further, an updated encoded garment graph is obtained by iteratively performing a message passing algorithm on the encoded garment graph, wherein every node aggregates one or more features from associated one or more incident edges, wherein the aggregated one or more features are processed to update own features, and are broadcasted to one or more neighboring nodes, and every edge node updates own features by taking the features from associated end nodes. Further, the per-vertex displacement of the garment template is determined by passing the updated garment graph through a displacement decoder.

In another embodiment of the system, the plurality of parameters include a) a relative position of garment template vertex with respect to closest canonical pose body vertex, b) relative position of ARAP deformed garment template vertex with respect to closest target pose body vertex, c) a normal vector of the body vertex, d) a pin vertex indicator, e) a body motion vector, and f) a mass of the garment template vertex proportional to the area of associated faces.

In another embodiment of the system, the one or more hardware processors are configured compute the restrain loss as:

$$l_{str} = \sum_{(i,j) \in E} \left( \frac{\varphi_{ij} - \mu_{fabric}}{\sigma_{fabric}} \right)^2,$$

where,

$\varphi_{ij}$ represents an absolute edge length difference, wherein the absolute edge length difference is absolute difference between length of an edge in the garment template and associated edge length in the deformed garment template, $\mu_{fabric}$ is fabric specific mean of the absolute edge length difference, and $\sigma_{fabric}$ is standard deviation of the absolute edge length difference.

In yet another embodiment of the system, the initial body pose is a 3D human body in the canonical body pose.

In yet another embodiment, a non-transitory computer readable medium is provided. The non-transitory computer readable medium includes a plurality of instructions, which when executed, cause the one or more hardware processors to obtain a garment template, an initial body pose, and a target body pose, as input data. Further, the garment template is aligned via the one or more hardware processors, on the target body pose, by estimating a body motion-aware as-rigid-as-possible (ARAP) garment deformation from the obtained input data. Further, a per-vertex displacement of the garment template is determined, via the one or more hardware processors, using a Physics Enforcing Network (PEN) based on the obtained input data and the estimated body motion-aware ARAP garment deformation. The PEN is trained using a restrain energy loss, wherein computing the restrain energy loss comprises: estimating absolute difference between edge length in the garment template and an associated edge length in a deformed garment template obtained using the motion-aware ARAP, for all of a plurality of edges; and computing the restrain energy loss based on the estimated absolute difference. Further, a final deformed garment template is generated via the one or more hardware processors, for the target pose, by adding the determined per-vertex displacement of the garment template to the estimated body motion-aware ARAP garment deformation.

In yet another embodiment, the non-transitory computer readable medium causes the one or more hardware processors to estimate a body motion-aware as-rigid-as-possible (ARAP) garment deformation by obtaining an index set of handle vertices of the garment template and associated displacement locations. Further, a displacement vector is computed for each handle vertex in the index set of handle vertices, with respect to position of the handle vertex indicated by the associated displacement location. Further, the following steps are performed for a pre-defined number of iterations: moving the handle vertices towards a final location in direction of the displacement vector, in a plurality of iterations; solving each non-handle vertex using ARAP; and solving collision of one or more of the handle vertices with body in the target body pose, comprising: identifying index of closest body vertex for each deformed non-handle vertex, and associated unit normal vector; identifying one or more collided vectors as projection of body to a garment vector onto the unit normal vector; and resolving identified collision by moving the one or more collided vectors towards a closest body vertex normal with a defined magnitude.

In yet another embodiment, the non-transitory computer readable medium causes the one or more hardware processors to determine the per-vertex displacement of the garment template using the Physics Enforcing Network (PEN), based on the following steps. Initially, one or more latent features of the garment template and the initial body pose are obtained from a geometry encoder. Further, the one or more latent features are concatenated with a plurality of parameters to obtain concatenated feature vector. Further, a node feature vector is obtained by processing the concatenated feature vector using a node encoder. Further, a relative position of edge end-vertices in the garment template and estimated garment deformation are determined. Further, the determined relative position of edge end-vertices are encoded into an edge feature vector using an edge encoder. Further, an encoded garment graph is constructed using the node feature vector and edge feature vector. Further, an updated encoded garment graph is obtained by iteratively performing a message passing algorithm on the encoded garment graph, wherein every node aggregates one or more features from associated one or more incident edges, wherein the aggregated one or more features are processed to update own features, and are broadcasted to one or more neighboring nodes, and every edge node updates own features by taking the features from associated end nodes. Further, the per-vertex displacement of the garment template is determined by passing the updated garment graph through a displacement decoder.

In yet another embodiment of the non-transitory computer readable medium, the plurality of parameters include a) a relative position of garment template vertex with respect to closest canonical pose body vertex, b) relative position of ARAP deformed garment template vertex with respect to closest target pose body vertex, c) a normal vector of the body vertex, d) a pin vertex indicator, e) a body motion vector, and f) a mass of the garment template vertex proportional to the area of associated faces.

In yet another embodiment, the non-transitory computer readable medium causes the one or more hardware processors to compute the restrain loss as:

$$l_{str} = \sum_{(i,j) \in E} \left( \frac{\varphi_{ij} - \mu_{fabric}}{\sigma_{fabric}} \right)^2,$$

where,

$\varphi_{ij}$ represents an absolute edge length difference, wherein the absolute edge length difference is absolute difference between length of an edge in the garment template and associated edge length in the deformed garment template, $\mu_{fabric}$ is fabric specific mean of the absolute edge length difference, and $\sigma_{fabric}$ is standard deviation of the absolute edge length difference.

In yet another embodiment of the non-transitory computer readable medium, the initial body pose is a 3D human body in the canonical body pose.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates an exemplary system for generic garment simulation, according to some embodiments of the present disclosure.
FIG. 2 is a flow diagram depicting steps involved in the process of the generic garment simulation, by the system of FIG. 1, according to some embodiments of the present disclosure.
FIG. 3 is a flow diagram depicting steps involved in the process of estimating a body motion-aware as-rigid-as-possible (ARAP) garment deformation, by the system of FIG. 1, in accordance with some embodiments of the present disclosure.
FIG. 4 is a flow diagram depicting steps involved in the process of solving collision of one or more of the handle vertices with body in the target body pose, by the system of FIG. 1, according to some embodiments of the present disclosure.
FIGS. 5A and 5B (collectively referred to as FIG. 5) is a flow diagram depicting steps involved in the process of determining the per-vertex displacement of the garment template using the Physics Enforcing Network (PEN), by the system of FIG. 1, in accordance with some embodiments of the present disclosure.
FIGS. 6 through 15 depict examples figures associated with the process of the generic garment simulation by the system of FIG. 1, according to some embodiments of the present disclosure.

DETAILED DESCRIPTION OF EMBODIMENTS

Exemplary embodiments are described with reference to the accompanying drawings. In the figures, the leftmost digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Some of the state of the art approaches for 3D garment simulation are data-driven learning-based simulation approaches as they reduce dependency on experts, and the time complexity of the simulation significantly. However, they have several limitations. Many of these methods 1) Work on fixed garment type: for instance Physically Based Neural Simulation (PBNS), Self-supervised Neural dynamic Garments (SNUG), VBones, and DD3DG can simulate only the garment template/type which is used for training thereby requiring a new model for each garment type. 2) Work on fixed body shapes: VBones and PBNS work on the fixed body shape used for training. 3) Assume fixed garment topology: methods such as Deep- Draper, and TailorNet assume different sizes of garments to have the same number of vertices, hence cannot model loose and long garments such as skirts and dresses, which require more number of vertices to accurately represent the geometry (wrinkles and folds). The existing supervised methods are trained primarily by minimizing L2 distance w.r.t the PBS data. Minimizing such L2 distance jointly for multiple tight and loose garments tends to learn average displacement and compromise the physical plausibility of the deformation.

To address these challenges, a method and system for generic garment simulation are provided. The method includes obtaining a garment template, an initial body pose, and a target body pose, as input data. Further, the garment template is aligned on the target body pose, by estimating a body motion-aware as-rigid-as-possible (ARAP) garment deformation from the obtained input data. Further, a per-vertex displacement of the garment template is determined using a Physics Enforcing Network (PEN) based on the obtained input data and the estimated body motion-aware ARAP garment deformation. The PEN is trained using a restrain energy loss. Computing the restrain energy loss comprises: estimating absolute difference between edge length in the garment template and an associated edge length in a deformed garment template obtained using the motion-aware ARAP, for all of a plurality of edges; and computing the restrain energy loss based on the estimated absolute difference. Further, a final deformed garment template is generated via the one or more hardware processors, for the target pose, by adding the determined per-vertex displacement of the garment template to the estimated body motion-aware ARAP garment deformation.

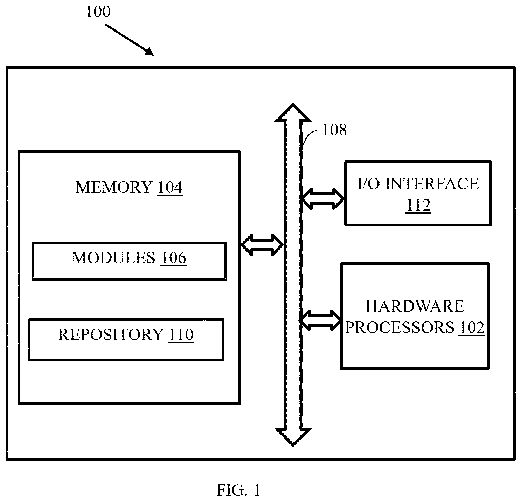

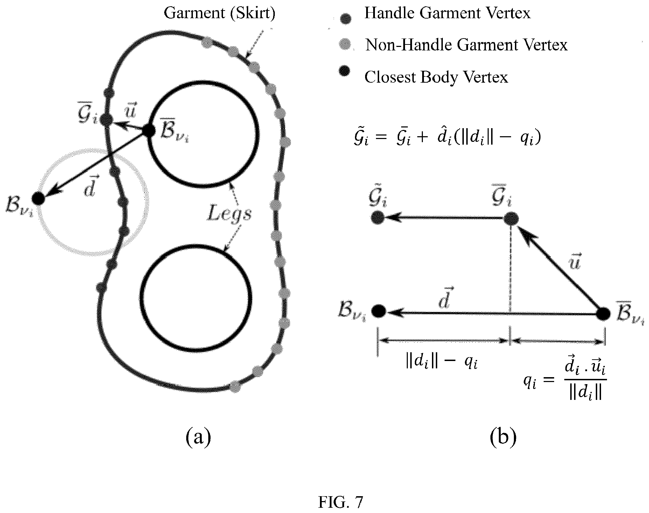

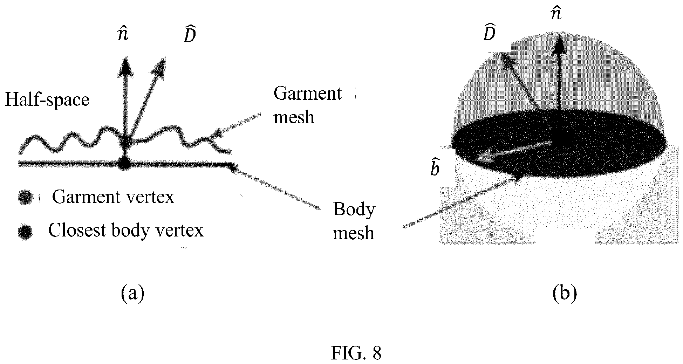

Referring now to the drawings, and more particularly to FIG. 1 through FIG. 15, where similar reference characters denote corresponding features consistently throughout the figures, there are shown preferred embodiments and these embodiments are described in the context of the following exemplary system and/or method.

FIG. 1 illustrates an exemplary system for generic garment simulation, according to some embodiments of the present disclosure.

The system 100 includes or is otherwise in communication with hardware processors 102, at least one memory such as a memory 104, an I/O interface 112. The hardware processors 102, memory 104, and the Input /Output (I/O) interface 112 may be coupled by a system bus such as a system bus 108 or a similar mechanism. In an embodiment, the hardware processors 102 can be one or more hardware processors.

The I/O interface 112 may include a variety of software and hardware interfaces, for example, a web interface, a graphical user interface, and the like. The I/O interface 112 may include a variety of software and hardware interfaces, for example, interfaces for peripheral device(s), such as a keyboard, a mouse, an external memory, a printer and the like. Further, the I/O interface 112 may enable the system 100 to communicate with other devices, such as web servers, and external databases.

The I/O interface 112 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface 112 may include one or more ports for connecting several computing systems with one another or to another server computer. The I/O interface 112 may include one or more ports for connecting several devices to one another or to another server.

The one or more hardware processors 102 may be implemented as one or more microprocessors, microcomputers, microcontrollers, digital signal processors, central processing units, node machines, logic circuitries, and/or any devices that manipulate signals based on operational instructions. Among other capabilities, the one or more hardware processors 102 is configured to fetch and execute computer-readable instructions stored in the memory 104.

The memory 104 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, the memory 104 includes a plurality of modules 106.

The plurality of modules 106 include programs or coded instructions that supplement applications or functions performed by the system 100 for executing different steps involved in the process of generic garment simulation, being performed by the system 100. The plurality of modules 106, amongst other things, can include routines, programs, objects, components, and data structures, which performs particular tasks or implement particular abstract data types. The plurality of modules 106 may also be used as, signal processor(s), node machine(s), logic circuitries, and/or any other device or component that manipulates signals based on operational instructions. Further, the plurality of modules 106 can be used by hardware, by computer-readable instructions executed by the one or more hardware processors 102, or by a combination thereof. The plurality of modules 106 can include various sub-modules (not shown). The plurality of modules 106 may include computer-readable instructions that supplement applications or functions performed by the system 100 for the generic garment simulation.

The data repository (or repository) 110 may include a plurality of abstracted piece of code for refinement and data that is processed, received, or generated as a result of the execution of the plurality of modules in the module(s) 106.

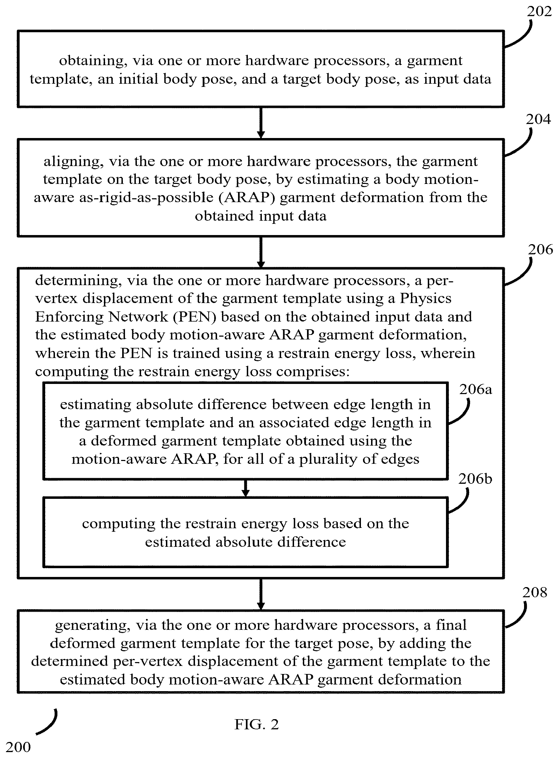

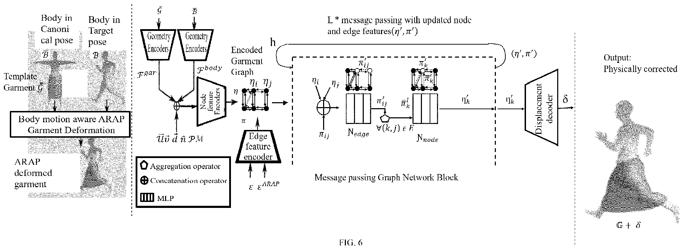

Although the data repository 110 is shown internal to the system 100, it will be noted that, in alternate embodiments, the data repository 110 can also be implemented external to the system 100, where the data repository 110 may be stored within a database (repository 110) communicatively coupled to the system 100. The data contained within such external database may be periodically updated. For example, new data may be added into the database (not shown in FIG. 1) and/or existing data may be modified and/or non-useful data may be deleted from the database. In one example, the data may be stored in an external system, such as a Lightweight Directory Access Protocol (LDAP) directory and a Relational Database Management System (RDBMS). Functions of the components of the system 100 are now explained with reference to the steps in flow diagrams in FIG. 2, FIG. 3, FIG. 4, and FIG. 5, and the example figures from FIG. 6 through FIG. 15.

FIG. 2 is a flow diagram depicting steps involved in the process of the generic garment simulation, by the system of FIG. 1, according to some embodiments of the present disclosure.

In an embodiment, the system 100 comprises one or more data storage devices or the memory 104 operatively coupled to the processor(s) 102 and is configured to store instructions for execution of steps of a method 200 by the processor(s) or one or more hardware processors 102. The steps of the method 200 of the present disclosure will now be explained with reference to the components or blocks of the system 100 as depicted in FIG. 1 and the steps of flow diagram as depicted in FIG. 2. Although process steps, method steps, techniques or the like may be described in a sequential order, such processes, methods, and techniques may be configured to work in alternate orders. In other words, any sequence or order of steps that may be described does not necessarily indicate a requirement that the steps to be performed in that order. The steps of processes described herein may be performed in any order practical. Further, some steps may be performed simultaneously.

At step 202 of method 200 of FIG. 2, the system 100 obtains, via the one or more hardware processors 102, a garment template $\overline{\mathcal{G}}$, an initial body pose, and a target body pose $\mathcal{B}$, as input data.

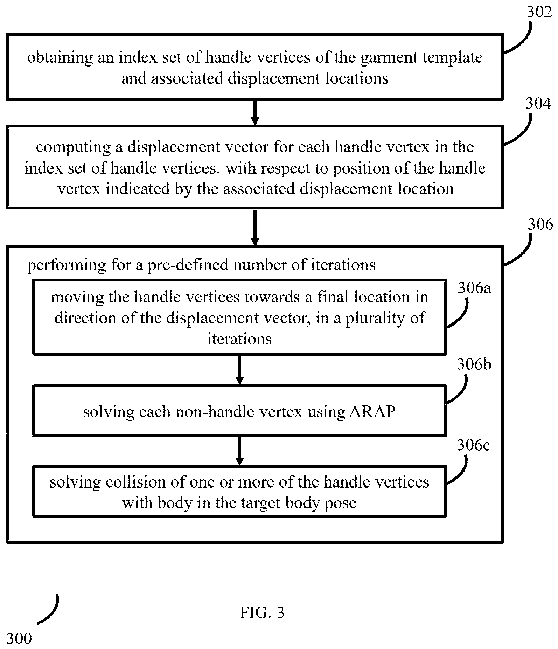

Further, at step 204 of the method 200, the garment template is aligned via the one or more hardware processors, on the target body pose, by estimating a body motion-aware as-rigid-as-possible (ARAP) garment deformation from the obtained input data. Steps involved in the process of aligning the garment template on the target body pose, using the motion-aware ARAP are depicted in method 300 in FIG. 3 and are explained hereafter.

The motion-aware ARAP deforms the garment in the presence of the human body as an obstacle. The handle vertices considered in this process are garment vertices under direct influence of the force exerted by the motion of the underlying body. At step 302 of the method 300, the system 100 indexes of the handle vertices of the garment in the set $\mathcal{H}$ and associated displaced locations $\widehat{\mathcal{G}_i}$, $\forall i \in \mathcal{H}$ are obtained as input. Values of $\mathcal{H}$ and $\mathcal{G}_i$ are obtained as explained below.

Let $\mathcal{B}$ and $\overline{\mathcal{B}}$ contain the vertices of the body in the initial and the target body poses respectively, and $\omega$ is an index set of the garment pin vertices. The system 100 finds a relative motion $\vec{d_i}$ of a body vertex closest to each template garment vertex. Similarly, the system 100 computes the relative position vector $u_i$ of the template garment vertex with respect to the closest body vertex. The angle between $d_i$ and $u_i$ indicates the set of garment vertices that are under the direct influence of the force due to the body motion. Locations of handle vertices are computed by moving them along the direction of motion with a magnitude ($\|d\|$ - q). Further the system 100 moves the garment pin vertices such that their relative positions with respect to the body surface pin area remains approximately the same. The system 100 then updates the handle vertices index set $\mathcal{H}$ by adding pin vertices to that set so that the location of pin vertices are not changed.

Further, at step 304 of the method 300, the system 100 computes a displacement vector $\vec{g_i}$ for each ith handle vertex in the index set of handle vertices, with respect to position of the handle vertex indicated by the associated displacement location.

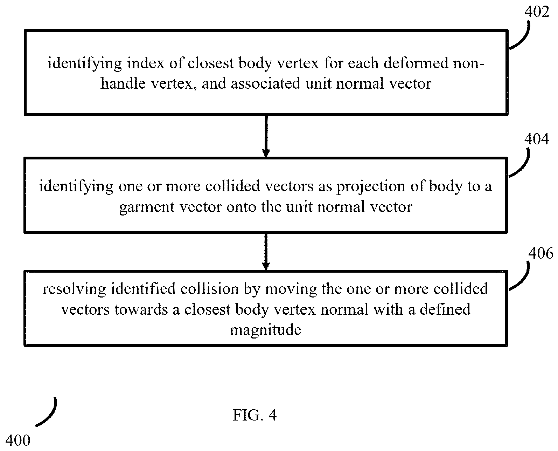

Further, at step 306 of the method 300, the system 100 performs substeps 306a through 306c for a pre-defined number of iterations. At step 306a, the system 100 moves the handle vertices towards a final location in direction of the displacement vector, in a plurality of iterations. The movement in each iteration is according to a step size t, which may be a pre-defined value. At step 306b, the system 100 solves each non-handle vertex using ARAP, i.e. using state of the art ARAP technique. Further, the system 100 determines if any of the non-handle vertices collide with the target body. If any of the non-handle vertices is found to be colliding with the target body, at step 306c, the system 100 solves the identified collision. Various steps in the process of solving the identified solution are depicted in method 400 in FIG. 4, and are explained hereafter.

At step 402 of the method 400, the system 100 identifies index $v_i$ of closest body vertex for each deformed non-handle vertex $\mathbb{G}_i$ , and associated unit normal vector $\hat{n}_{v_i}$. Here, projection of the body to the garment vector onto the unit normal vector can indicate the collided vertices, as depicted in step 404 of the method 400. Further, at step 406 of the method 400, the system 100 resolves the identified collision by moving the one or more collided vectors towards a closest body vertex normal $\hat{n}_{v_i}$ with a defined magnitude $|\delta|$. In the iterative movement as explained in the method 400, values of the total number of iterations, and the step size in each iteration are pre-defined.

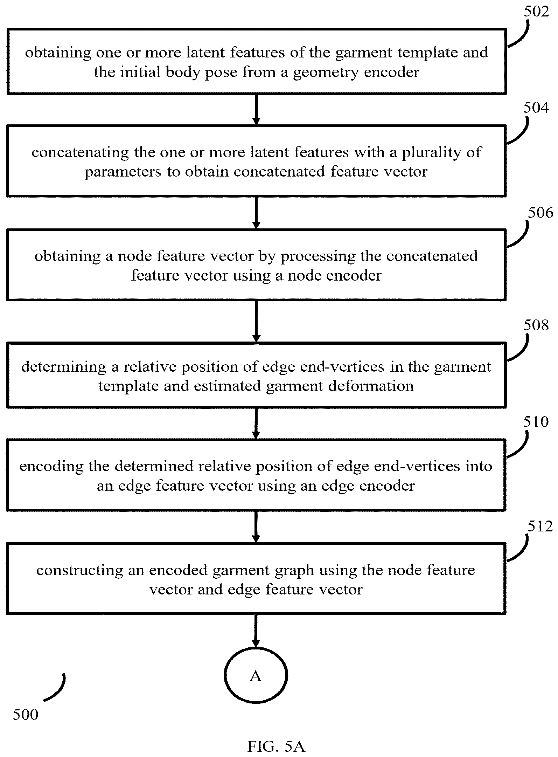

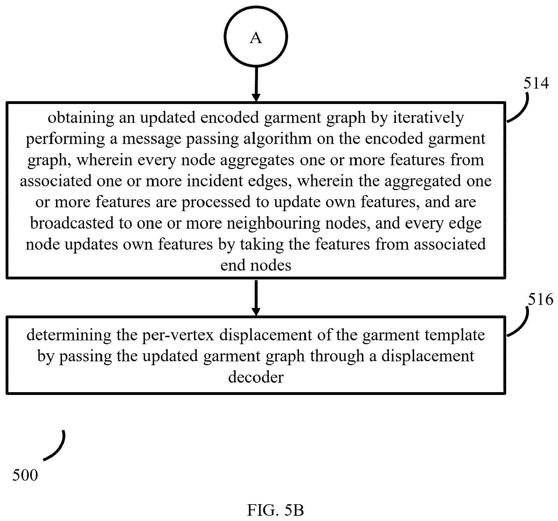

Referring back to the method 200, the obtained Body Motion-aware ARAP deformed garment may not be physically plausible as it is deformed under as-rigid-as-possible constraints. To make it physically plausible, at step 206 of the method 200, the system 100 uses a Physics Enforcing Network (PEN) which determines a displacement or correction for every vertex (i.e. per-vertex displacement), which is then added to make the ARAP deformed garment physically plausible. Various steps in the process of determining the per-vertex displacement of the garment template using the PEN are depicted in method 500 in FIG. 5, and are explained hereafter.

The physical plausibility of the deformed garment depends on several factors such as the shape and size of the template garment, the body motion, etc. Such features are encoded into the garment graph node feature. Similarly, the relative position of the edge end-vertices of the garment mesh are encoded into the edge features of the garment graph.

At step 502 of the method 500, the system 100 obtains one or more latent features of the garment template and the initial body pose, from a geometry encoder. Let $\eta_i$ and $\pi_l$ denote the $i^{th}$ and $l^{th}$ latent node and edge feature vectors of the encoded garment graph respectively. Process of obtaining the one or more latent features is explained below.

In this process, geometry of each vertex of the template garment and the underlying body mesh are encoded using a geometry encoder. Let $F_i^{gar}$ and $F_{v_i}^{body}$ denote the latent geometry feature of $i^{th}$ template garment vertex and its closest body vertex $\overline{B_i}$ . The latent geometric feature vectors are concatenated with the relative position of garment vertex w.r.t its closest canonical pose body vertex $\vec{u}_i = \vec{G}_i - \vec{B}_{v_i}$ , the relative position of ARAP deformed garment vertex w.r.t its closest target pose body vertex $\vec{v}_i = G_i - B_{v_i}$ , the normal vector $\hat{n}_i$ of the body vertex $B_{v_i}$ , the pin vertex indicator $\mathcal{P}_i$ ( $\mathcal{P}_i$ = 1 for pin vertices, else 0), the body motion vector $d_i$, and the mass $\mathcal{M}_i$ of the garment vertex, which is proportional to the area of its associated faces. The concatenated input

$$[F_i^{gar}, F_{v_i}^{body}, \vec{u}, \vec{v}, \vec{d}, \hat{n}, \mathcal{p}, \mathcal{M}]$$

is processed through the geometric encoder to get the latent node feature vector $\eta_i$.

Similarly, the latent edge features are obtained as below.

Relative position of edge end vertices in $\bar{\mathcal{G}}$ and $\mathbb{G}$ are determined as $\varepsilon_{ij} = \bar{\mathcal{G}}_j - \bar{\mathcal{G}}_i$ and $\epsilon_{ij}^{ARAP} = \mathbb{G}_j - \mathbb{G}_i$ respectively. Encoding both $\varepsilon_{ij}$ and $\epsilon_{ij}^{ARAP}$ using latent edge feature $\pi$ helps to correct any significant elongation/compression in the ARAP deformed garment edges.

Further, at step 504 of the method 500, the system 100 concatenates one or more latent features with a plurality of parameters to obtain concatenated feature vector. The plurality of parameters include a) a relative position of garment template vertex with respect to closest canonical pose body vertex, b) relative position of ARAP deformed garment template vertex with respect to closest target pose body vertex, c) a normal vector of the body vertex, d) a pin vertex indicator, e) a body motion vector, and f) a mass of the garment template vertex proportional to the area of associated faces. Further, at step 506 of the method 500, the system 100 obtains a node feature vector by processing the concatenated feature vector using a node encoder. Further, at step 508 of the method 500, the system 100 determines a relative position of edge end-vertices in the garment template and estimated garment deformation. Further, at step 510 of the method 500, the system 100 encodes the determined relative position of edge end-vertices into an edge feature vector using an edge encoder. Further, at step 512 of the method 500, the system 100 constructs an encoded garment graph using the node feature vector and edge feature vector.

Further, at step 514 of the method 500, an updated encoded garment graph is obtained by iteratively performing a message passing algorithm on the encoded garment graph, wherein every node aggregates one or more features from associated one or more incident edges, wherein the aggregated one or more features are processed to update own features, and are broadcasted to one or more neighboring nodes, and every edge node updates own features by taking the features from associated end nodes. The message passing is repeated for **L** steps.

Further, at step 516 of the method 500, the per-vertex displacement of the garment template is determined by passing the updated garment graph through a displacement decoder. The final encoded garment graph node features are used by the displacement decoder to produce per vertex direction $\hat{D}$ and the magnitude $\omega$ of the displacement, which is added to the ARAP deformed garment vertices so that the final garment deformation becomes physically plausible. The final predicted deformed garment

$$\mathcal{G}^{pred} = \mathbb{G} + \hat{D}\omega \qquad \text{--- (1)}$$

To ensure that the direction of displacement $\hat{D}$ of a garment vertex $\mathbb{G}_i$ is not inducing any collision with the local body surface patch around its closest body vertex $\mathcal{B}_{v_i}$, it is restricted to be outwards to the local body surface patch, i.e. in the half-space towards the unit normal $\hat{n}_i$ of the body vertex $\mathcal{B}_{v_i}$. Value of $\hat{D}$ can be obtained as a convex combination of vectors $\hat{n}$ and $\hat{b}$. Let $[b^1, b^2, b^3]$ are coefficients of $\vec{b}$, and $\hat{b} = \vec{b}/\|\vec{b}\|$. As $\vec{b}$ may be orthogonal to $\vec{n}$, $\vec{n}. \vec{b} = 0$. Hence, $b^3 = \dfrac{-b^1 n^1 - b^1 n^2}{n^3}$, where $[n^1, n^2, n^3]$ are coefficients of known body vertex unit $\hat{n}$.

The displacement decoder predicts the values of $b^1, b^2$, a convex combination factor $\rho$, and the magnitude of displacement $\omega$ for each garment vertex. The coefficient $b^3$ of the direction vector can be estimated from $b^1$ and $b^2$ as above. The unit direction vector $\widehat{\mathcal{D}}$ is then obtained as $\widehat{\mathcal{D}} = \vec{\mathcal{D}}/\|\vec{\mathcal{D}}\|$, where $\vec{\mathcal{D}}$ is estimated as:

$$\vec{\mathcal{D}} = |\rho| \hat{n} + (1 - |\rho|) * \frac{\rho}{|\rho|} \hat{b} \qquad \text{--- (2)}$$

Where, $\rho$ is output of **Tanh** activation, hence $|\rho|$ is used to ensure the convex combination ($0 \le |\rho| \le 1$) of $\hat{n}$ and $\hat{b}$. To consider both $\hat{b}$ and $-\hat{b}$ as valid solutions, $\hat{b}$ is multiplied with $\dfrac{\rho}{|\rho|}$ as this factor can be either +1 or -1, and is predicted by the displacement decoder.

Referring back to the method 200, at step 208 of the method 200, the system 100 generates a final deformed garment template is generated via the one or more hardware processors, for the target pose, by adding the determined per-vertex displacement of the garment template to the estimated body motion-aware ARAP garment deformation.

In an embodiment, the PEN is trained using a restrain energy loss. Computing the restrain energy loss includes the following steps. Initially, an absolute difference between edge length in the garment template and an associated edge length in a deformed garment template obtained using the motion-aware ARAP is estimated for all of a plurality of edges. Further, the restrain energy loss is computed based on the estimated absolute difference. The restrain loss is computed as:

$$l_{str} = \sum_{(i,j) \in E} \left(\frac{\varphi_{ij} - \mu_{fabric}}{\sigma_{fabric}}\right)^2, \qquad \text{--- (3)}$$

where, $\varphi_{ij}$ represents an absolute edge length difference, wherein the absolute edge length difference is absolute difference between length of an edge in the garment template and associated edge length in the deformed garment template, $\mu_{fabric}$ is fabric specific mean of the absolute edge length difference, and $\sigma_{fabric}$ is standard deviation of the absolute edge length difference.

In an embodiment, the system 100 may compute a total training loss of the PEN as a sum of the restrain energy loss with a bending energy, a pin vertices loss, a potential energy, a mesh smoothness loss, and a garment-to-body-collision penalty loss. Details of calculation of each of these parameters is given below:

Bending Energy: The bending loss term measures the energy due to the angle between two adjacent garment faces, and is modelled as:

$$\ell_{ben} = \sum_{(i,j)} \frac{\|\mathcal{E}_{ij}^{pred}\|^2}{4(A_1 + A_2)} \left(\frac{\theta^2}{2}\right) \qquad \text{--- (4)}$$

where, $A_1$ and $A_2$ are the areas of the adjacent faces, $\varepsilon_{ij}^{pred}$ is the common edge connecting two adjacent faces, and $\theta$ is the dihedral angle between the adjacent faces.

Pin Vertices Loss: The movement of the pin vertices are restricted from their respective location in the ARAP deformed garment **G**, which prevents the garment from falling down. **L2** regularization loss is applied between vertices in G and G$^{pred}$. Here, $\omega$ is the index set of pin vertices.

$$\ell pin = \mathrm{X} \| G_i - G_i pred \|2 \qquad \text{--- (5)}$$
$$i \in \omega$$

Potential Energy: The potential energy loss term measures the energy due to the gravitational force, which is modeled as below, where g is the gravitational acceleration, $z_i$ is the height of the final deformed garment vertex $G_i^{pred}$, and $M_i$ is the mass of the garment vertex. The potential energy loss for all the non-pin vertices is computed.

$$\ell_{pe} = \mathrm{X}\, \mathrm{M}_i\, \mathrm{g}\, z_i \qquad \text{---- (6)}$$
$$i \in \{I \backslash \omega\}$$

Mesh Smoothness Loss: To enforce locally smooth surfaces of predicted garment mesh G$^{pred}$, the system 100 applies Laplacian smoothing loss with cotangent weights. Here, $\triangle$ is the Laplacian smoothing operator.

$$\ell sm = \triangle(Gpred) \qquad \text{--- (7)}$$

Garment-to-Body Collision Penalty Loss: The direction of displacement used by the system 100, by design avoids collisions locally. However, if the garment vertex needs to move a lot i.e., when the magnitude of the displacement is large, in such cases the vertex may collide with the non-local body surfaces. This happens mainly when the garment lies between the two body parts, where the normal of both the body parts are facing each other (e.g., the garment lies between the folded leg i.e., between the back side of the thigh and the calf muscle body area). To handle those scenarios the system 100 applies a garment-to-body collision penalty loss as:

$$l_{col} = \sum_{i \in I} \max\left(-\hat{n}_i\left(\mathcal{B}_{v_i} - \mathcal{G}_i^{pred}\right), \epsilon_{coll}\right) \qquad \text{--- (8)}$$

where, $\mathcal{B}_{v_i}$ is the body vertex closest to the final deformed garment vertex $\mathcal{G}_i^{pred}$, and $\hat{n}_i$ is the unit vertex normal of $\mathcal{B}_{v_i}$. $\varepsilon_{coll}$ is the collision threshold for robustness.

Further, the total loss L is calculated as:

$$L = \gamma 1 \ell str + \gamma 2 \ell ben + \gamma 3 \ell pin + \gamma 4 \ell pe + \gamma 5 \ell sm + \gamma 6 \ell col, \qquad \text{--- (9)}$$

Where, $\gamma$'s are the balancing weights of the loss terms.

Experimental Data:

For the experiments, the system 100 was trained on a subset of 175 sequences with tops and skirts outfits from the training split of the CLOTH3D dataset and was tested on 60 sequences from the test split from this dataset.

Results on CLOTH 3D Test Set:-

Quantitative: To demonstrate performance of data model used by the system 100, for predicting more accurate physically plausible garment deformations, two variants, one with unsupervised losses, and another using L2 loss on predicted garment vertices, were used. Both variants were compared on the test set using metrics for average edge compression/elongation with respect to their length in the template garment, garment surface quality smoothness measured using the Laplacian loss term used in calculation of the mesh smoothness loss, and the percentage of garment vertices collisions with the body. As the per results in Table 1, the variant trained with physics-based losses appeared to be producing better quality garment deformations owing to lower edge distortion, smoother garment surfaces, and significantly lower body-to-garment collision. In the first variant, the L2 loss learns the ground-truth data in an average sense, which leads to elongation/compression of some edges and collisions. On the other hand, unsupervised losses in the system 100 compute the garment deformation that reduces the overall energy of the garment, while restraining edge lengths from changing too much, and also avoiding collisions, thereby, producing better results.

Table 1. Quantitative Evaluation on CLOTH3D Test Set

| Training Strategy | | Edge (mm) | Smoothness | Collision (%) |
| --- | --- | --- | --- | --- |
| Supervised Smoothness + Collision Loss | L2 | + 3.8 | 0.0013 | 10.1 |
| Unsupervised Losses | Physics | 1.9 | 0.0008 | 0.6 |

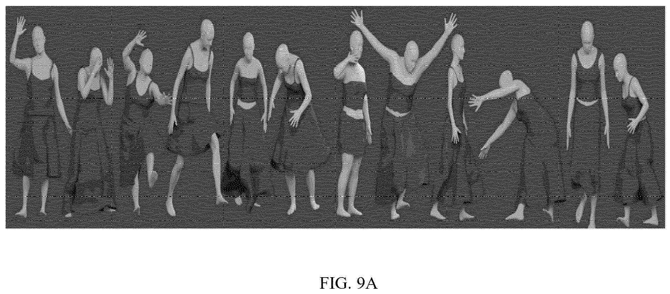

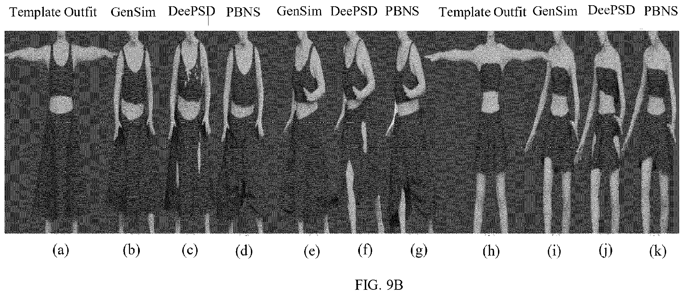

Qualitative: Sample qualitative results of *the method 200* on various unseen body shapes, poses, and garments of various types, sizes, and topologies are shown in FIG. 9a. *The method 200* produced physically plausible simulations.
Comparison with PBNS, and DeePSD: Results of these different approaches were qualitatively compared with PBNS and DeePSD on CLOTH3D test samples. Since PBNS is an outfit-body specific method, the two PBNS models were trained one for each outfit-body pair in (a) and (h) in FIG. 9b. DeePSD was trained on the same training set of tops and skirts as *the method 200.* Note: For PBNS both the training and testing garment template is the same, whereas the testing garment template is unseen for both DeePSD and *Method 200* during training. DeePSD suffered from collisions (in © and (j) in FIG. 9b), PBNS produced similar artifacts for skirts (between legs) as in (d) and (k) in FIG. 9b.

Generalization on Unseen Garment Types

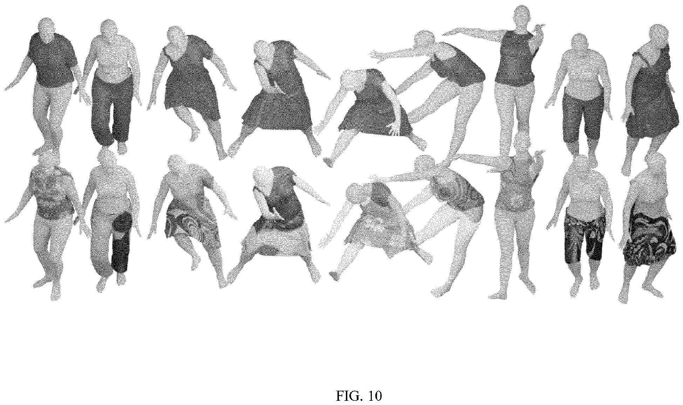

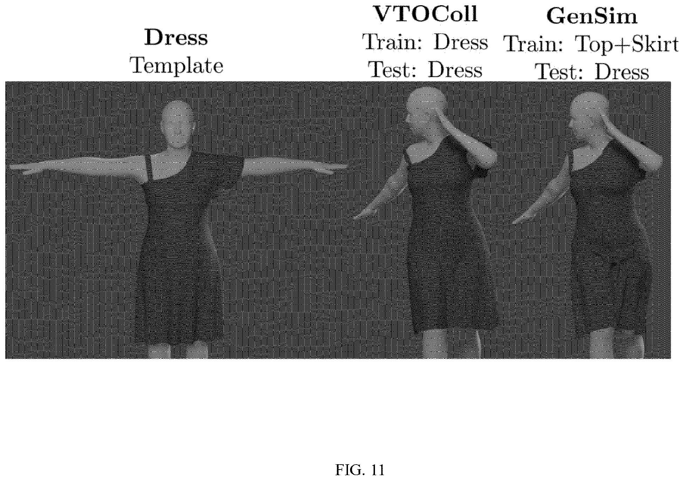

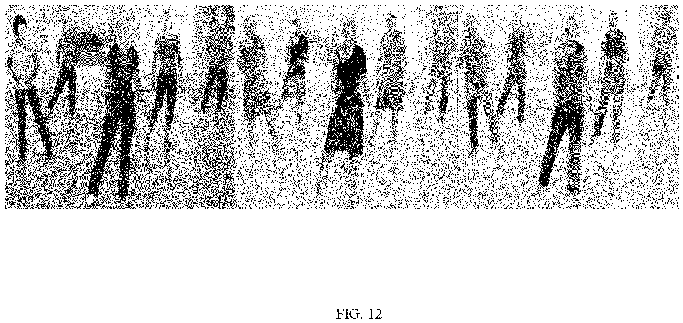

Generalization capability of *the method 200 was evaluated* by evaluating it on unseen garment types (dress, t-shirt, pant, shorts, tank) of different topologies from a VTO-dataset. The results shown in FIG. 10 show that despite being trained only on tops and skirts *the method 200* generalized well on unseen garments. Qualitative comparison with VTOCOLL is depicted in FIG. 11.
On a random YouTube® video: Results of *the method 200* draping unseen garments (pants, shorts, dress, and tank) on unseen body shapes and poses in a frame of random YouTube video is depicted in FIG. 12. PARE was used to estimate the body shape and pose of humans from the image.

Implementation Details

For the experiment, the method 200 was implemented using PyTorch. PointNet was used for the geometry encoders, the node and the edge feature encoders were MLPs. The method 200 *was trained* using adam optimizer for 30 epochs with an ini$\gamma_2 = \gamma_5 = 1.0$, $\varepsilon = -0.5$ and $\varepsilon_{coll} = 0.003$. The model size used in the method 200 was ~ 1MB. *The method 200 was found to be taking* average ~ 0.9 *secs* [0.6(ARAP)+ 0.3(PEN)] for inferring a 3000 vertices skirt as compared to on average 5 minutes taken by a physics based simulator ArcSim, similar time of ArcSim. The simulation of a garment on a static body pose is invariant to the global body rotation and position. Hence the target body pose was front aligned with respect to the template body pose (T-pose) by removing any global rotation and translation with respect to the T-pose body root joint.

Ablation Study

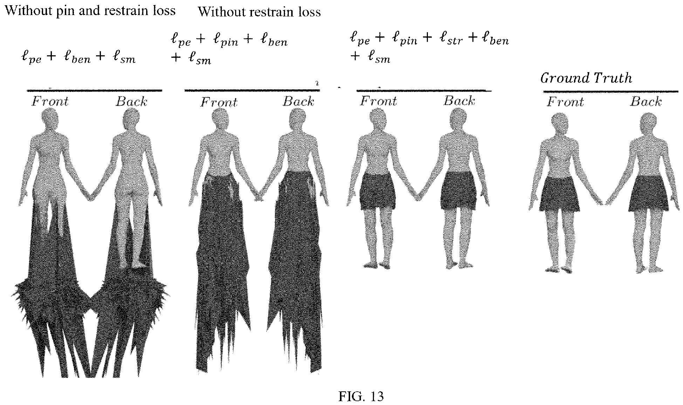

Losses Justification: It is well understood that Laplacian and the bending losses are important for maintaining the quality of garment surfaces. Effect of potential energy loss, pin loss and restrain loss were studied during the experiments. Three variants of PEN were trained on a small subset of 10 *random sequences of a short skirt.* $V1:(\ell_{pe}+\ell_{ben}+\ell_{sm})$, this variant was trained with potential energy loss ($\ell_{pe}$), Laplacian smoothing loss ($\ell_{sm}$), and bending loss ($\ell_{ben}$), V2: in addition to all the losses of V1, the pin loss ($\ell_{pin}$) was added, and in V3:, restrain loss (($\ell_{str}$) was added to the V2 losses. It was observed in FIG. 13, that in the V1 version, since the gravitation force was the only force acting on the vertices it led to the fall down of the garment. The V2 version held the garment with the pin vertices, however, the dominating gravitation energy pulled the vertices downwards which resulted in arbitrary elongation of the edges. The third version V3 with additional restrain loss, restrict edges to elongate arbitrarily due to the influence of the gravitation force. This demonstrates all the losses are important and necessary to train PEN in an unsupervised manner.

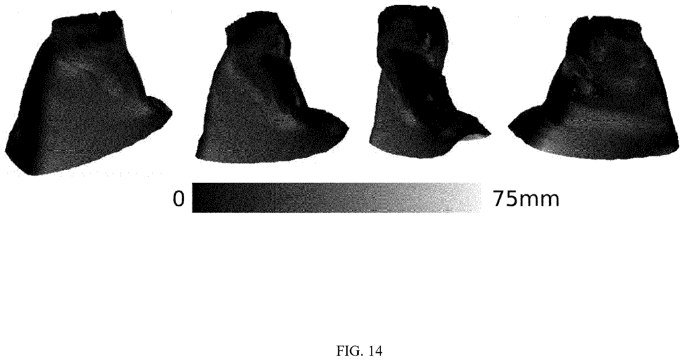

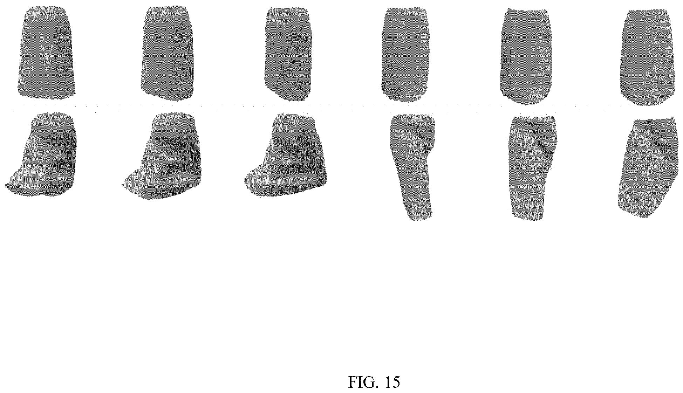

PEN output vs ARAP deformed garment: To demonstrate that PEN adds meaningful displacements to the ARAP deformed garment G to make it physically plausible, a displacement magnitude map is depicted in FIG. 14. The garment and the underlying body shape and pose were same as in FIG. 6. Maximum displacement magnitude produced by the PEN was 75mm. It was observed that PEN predicted the high magnitude of displacement for the vertices where the garment needs to displace due to the gravitational force, and where it falls on the body surface its magnitude becomes almost close to zero. Also, while producing the displacements for each vertex, PEN maintained the cloth quality. The rendered normal map of the template garment and the predicted garment were observed as in FIG. 15.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problem of generic garment simulation. The embodiment, thus provides a method and system for generic garment simulation. Moreover, the embodiments herein further provide a mechanism of generic garment simulation, using a combination of a body motion aware ARAP garment deformation and a Physics Enforcing Network (PEN).

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

1. A processor implemented method (200), comprising:

   obtaining (202), via one or more hardware processors, a garment template, an initial body pose, and a target body pose, as input data;
   aligning (204), via the one or more hardware processors, the garment template on the target body pose, by estimating a body motion-aware as-rigid-as-possible (ARAP) garment deformation from the obtained input data;
   determining (206), via the one or more hardware processors, a per-vertex displacement of the garment template using a Physics Enforcing Network (PEN) based on the obtained input data and the estimated body motion-aware ARAP garment deformation, wherein the PEN is trained using a restrain energy loss, wherein computing the restrain energy loss comprises:

      estimating (206a) absolute difference between an edge length in the garment template and an associated edge length in a deformed garment template obtained using the motion-aware ARAP, for all of a plurality of edges; and
      computing (206b) the restrain energy loss based on the estimated absolute difference; and
      generating (208), via the one or more hardware processors, a final deformed garment template for the target pose, by adding the determined per-vertex displacement of the garment template to the estimated body motion-aware ARAP garment deformation.

2. The method as claimed in claim 1, wherein estimating the body motion-aware as-rigid-as-possible (ARAP) garment deformation comprises:

   obtaining (302) an index set of handle vertices of the garment template and associated displacement locations;
   computing (304) a displacement vector for each handle vertex in the index set of handle vertices, with respect to position of the handle vertex indicated by the associated displacement location; and
   performing (306) for a pre-defined number of iterations:

      moving the handle vertices towards a final location in direction of the displacement vector, in a plurality of iterations;
      solving each non-handle vertex using ARAP; and
      solving collision of one or more of the handle vertices with body in the target body pose, comprising:

         identifying (402) index of closest body vertex for each deformed non-handle vertex, and associated unit normal vector;
         identifying (404) one or more collided vectors as projection of body to a garment vector onto the unit normal vector; and
         resolving (406) identified collision by moving the one or more collided vectors towards a closest body vertex normal with a defined magnitude.

3. The method as claimed in claim 1, wherein determining the per-vertex displacement of the garment template using the Physics Enforcing Network (PEN) comprises:

   obtaining (502) one or more latent features of the garment template and
   the initial body pose from a geometry encoder;
   concatenating (504) the one or more latent features with a plurality of parameters to obtain concatenated feature vector;
   obtaining (506) a node feature vector by processing the concatenated feature vector using a node encoder;
   determining (508) a relative position of edge end-vertices in the garment template and estimated garment deformation;

encoding (510) the determined relative position of edge end-vertices into an edge feature vector using an edge encoder;

constructing (512) an encoded garment graph using the node feature vector and edge feature vector;

obtaining (514) an updated encoded garment graph by iteratively performing a message passing algorithm on the encoded garment graph,

wherein every node aggregates one or more features from associated one or more incident edges, wherein the aggregated one or more features are processed to update own features, and are broadcasted to one or more neighboring nodes, and every edge node updates own features by taking the features from associated end nodes; and

determining (516) the per-vertex displacement of the garment template by passing the updated garment graph through a displacement decoder.

4. The method as claimed in claim 3, wherein the plurality of parameters include a) a relative position of garment template vertex with respect to closest canonical pose body vertex, b) relative position of ARAP deformed garment template vertex with respect to closest target pose body vertex, c) a normal vector of the body vertex, d) a pin vertex indicator, e) a body motion vector, and f) a mass of the garment template vertex proportional to the area of associated faces.

5. The method as claimed in claim 1, wherein the restrain loss is computed as:

$$l_{str} = \sum_{(i,j)\in E} \left( \frac{\varphi_{ij} - \mu_{fabric}}{\sigma_{fabric}} \right)^2 ,$$

where,

$\varphi_{ij}$ represents an absolute edge length difference, wherein the absolute edge length difference is absolute difference between length of an edge in the garment template and associated edge length in the deformed garment template,

$\mu_{fabric}$ is fabric specific mean of the absolute edge length difference, and

$\sigma_{fabric}$ is standard deviation of the absolute edge length difference.

6. The method as claimed in claim 1, wherein the initial body pose is a 3D human body in the canonical body pose.

7. A system, comprising:

one or more hardware processors;
a communication interface; and
a memory storing a plurality of instructions, wherein the plurality of instructions cause the one or more hardware processors to:

obtain a garment template, an initial body pose, and a target body pose, as input data;
align the garment template on the target body pose, by estimating a body motion-aware as-rigid-as-possible (ARAP) garment deformation from the obtained input data;
determine a per-vertex displacement of the garment template using a Physics Enforcing Network (PEN) based on the obtained input data and the estimated body motion-aware ARAP garment deformation, wherein the PEN is trained using a restrain energy loss, wherein computing the restrain energy loss comprises:

estimating absolute difference between an edge length in the garment template and an associated edge length in a deformed garment template obtained using the motion-aware ARAP, for all of a plurality of edges; and
computing the restrain energy loss based on the estimated absolute difference; and
generate a final deformed garment template for the target pose, by adding the determined per-vertex displacement of the garment template to the estimated body motion-aware ARAP garment deformation.

8. The system as claimed in claim 7, wherein the one or more hardware processors are configured to estimate the body motion-aware as-rigid-as-possible (ARAP) garment deformation, by:

obtaining an index set of handle vertices of the garment template and associated displacement locations;

computing a displacement vector for each handle vertex in the index set of handle vertices, with respect to position of the handle vertex indicated by the associated displacement location; and

performing for a pre-defined number of iterations:

moving the handle vertices towards a final location in direction of the displacement vector, in a plurality of iterations;

solving each non-handle vertex using ARAP; and

solving collision of one or more of the handle vertices with body in the target body pose, comprising:

identifying index of closest body vertex for each deformed non-handle vertex, and associated unit normal vector;

identifying one or more collided vectors as projection of body to a garment vector onto the unit normal vector; and

resolving identified collision by moving the one or more collided vectors towards a closest body vertex normal with a defined magnitude.

9.  The system as claimed in claim 7, wherein the one or more hardware processors are configured to determine the per-vertex displacement of the garment template using the Physics Enforcing Network (PEN), by:

obtaining one or more latent features of the garment template and the initial body pose from a geometry encoder;

concatenating the one or more latent features with a plurality of parameters to obtain concatenated feature vector;

obtaining a node feature vector by processing the concatenated feature vector using a node encoder;

determining a relative position of edge end-vertices in the garment template and estimated garment deformation;

encoding the determined relative position of edge end-vertices into an edge feature vector using an edge encoder;

constructing an encoded garment graph using the node feature vector and edge feature vector;

obtaining an updated encoded garment graph by iteratively performing a message passing algorithm on the encoded garment graph, wherein every node aggregates one or more features from associated one or more incident edges, wherein the aggregated one or more features are processed to update own features, and are broadcasted to one or more neighboring nodes, and every edge node updates own features by taking the features from associated end nodes; and

determining the per-vertex displacement of the garment template by passing the updated garment graph through a displacement decoder.

10. The system as claimed in claim 9, wherein the plurality of parameters include a) a relative position of garment template vertex with respect to closest canonical pose body vertex, b) relative position of ARAP deformed garment template vertex with respect to closest target pose body vertex, c) a normal vector of the body vertex, d) a pin vertex indicator, e) a body motion vector, and f) a mass of the garment template vertex proportional to the area of associated faces.

11. The system as claimed in claim 7, wherein the one or more hardware processors are configured to compute the restrain loss as:

$$l_{str} = \sum_{(i,j)\in E} \left( \frac{\varphi_{ij} - \mu_{fabric}}{\sigma_{fabric}} \right)^2,$$

where,

$\varphi_{ij}$ represents an absolute edge length difference, wherein the absolute edge length difference is absolute difference between length of an edge in the garment template and associated edge length in the deformed garment template,

$\mu_{fabric}$ is fabric specific mean of the absolute edge length difference, and

$\sigma_{fabric}$ is standard deviation of the absolute edge length difference.

12. The system as claimed in claim 7, wherein the initial body pose is a 3D human body in the canonical body pose.

13. One or more non-transitory machine-readable information storage mediums comprising one or more instructions which when executed by one or more hardware processors cause:

obtaining a garment template, an initial body pose, and a target body pose, as input data;
aligning the garment template on the target body pose, by estimating a body motion-aware as-rigid-as-possible (ARAP) garment deformation from the obtained input data;
determining a per-vertex displacement of the garment template using a Physics Enforcing Network (PEN) based on the obtained input data and
the estimated body motion-aware ARAP garment deformation, wherein
the PEN is trained using a restrain energy loss, wherein computing the restrain energy loss comprises:

estimating absolute difference between an edge length in the garment template and an associated edge length in a deformed garment template obtained using the motion-aware ARAP, for all of a plurality of edges; and
computing the restrain energy loss based on the estimated absolute difference; and
generating a final deformed garment template for the target pose, by adding the determined per-vertex displacement of the garment template to the estimated body motion-aware ARAP garment deformation.

14. The one or more non-transitory machine-readable information storage mediums as claimed in claim 13, wherein estimating the body motion-aware as-rigid-as-possible (ARAP) garment deformation comprises:

obtaining an index set of handle vertices of the garment template and
associated displacement locations;
computing a displacement vector for each handle vertex in the index set of handle vertices, with respect to position of the handle vertex indicated by the associated displacement location; and
performing for a pre-defined number of iterations:

moving the handle vertices towards a final location in direction of the displacement vector, in a plurality of iterations;
solving each non-handle vertex using ARAP; and
solving collision of one or more of the handle vertices with body in the target body pose, comprising:

identifying index of closest body vertex for each deformed non-handle vertex, and associated unit normal vector;
identifying one or more collided vectors as projection of body to a garment vector onto the unit normal vector; and
resolving identified collision by moving the one or more collided vectors towards a closest body vertex normal with a defined magnitude.

15. The one or more non-transitory machine-readable information storage mediums as claimed in claim 13, wherein determining the per-vertex displacement of the garment template using the Physics Enforcing Network (PEN) comprises:

obtaining one or more latent features of the garment template and the initial body pose from a geometry encoder;
concatenating the one or more latent features with a plurality of parameters to obtain concatenated feature vector;
obtaining a node feature vector by processing the concatenated feature vector using a node encoder;
determining a relative position of edge end-vertices in the garment template and estimated garment deformation;
encoding the determined relative position of edge end-vertices into an edge feature vector using an edge encoder;
constructing an encoded garment graph using the node feature vector and edge feature vector;
obtaining an updated encoded garment graph by iteratively performing a message passing algorithm on the encoded garment graph, wherein
every node aggregates one or more features from associated one or more incident edges, wherein the aggregated one or more features are processed to update own features, and are broadcasted to one or more neighboring nodes, and every edge node updates own features by taking the features from associated end nodes; and
determining the per-vertex displacement of the garment template by passing the updated garment graph through a displacement decoder.

100

108

MEMORY 104

MODULES 106

REPOSITORY 110

I/O INTERFACE
112

HARDWARE
PROCESSORS 102

FIG. 1

202

obtaining, via one or more hardware processors, a garment template, an initial body pose, and a target body pose, as input data

204

aligning, via the one or more hardware processors, the garment template on the target body pose, by estimating a body motion-aware as-rigid-as-possible (ARAP) garment deformation from the obtained input data

206

determining, via the one or more hardware processors, a per-vertex displacement of the garment template using a Physics Enforcing Network (PEN) based on the obtained input data and the estimated body motion-aware ARAP garment deformation, wherein the PEN is trained using a restrain energy loss, wherein computing the restrain energy loss comprises:

206a

estimating absolute difference between edge length in the garment template and an associated edge length in a deformed garment template obtained using the motion-aware ARAP, for all of a plurality of edges

206b

computing the restrain energy loss based on the estimated absolute difference

208

generating, via the one or more hardware processors, a final deformed garment template for the target pose, by adding the determined per-vertex displacement of the garment template to the estimated body motion-aware ARAP garment deformation

200

FIG. 2

302

obtaining an index set of handle vertices of the garment template and associated displacement locations

304

computing a displacement vector for each handle vertex in the index set of handle vertices, with respect to position of the handle vertex indicated by the associated displacement location

306

performing for a pre-defined number of iterations

306a

moving the handle vertices towards a final location in direction of the displacement vector, in a plurality of iterations

306b

solving each non-handle vertex using ARAP

306c

solving collision of one or more of the handle vertices with body in the target body pose

FIG. 3

300

402

identifying index of closest body vertex for each deformed non-handle vertex, and associated unit normal vector

404

identifying one or more collided vectors as projection of body to a garment vector onto the unit normal vector

406

resolving identified collision by moving the one or more collided vectors towards a closest body vertex normal with a defined magnitude

FIG. 4

400

502

obtaining one or more latent features of the garment template and the initial body pose from a geometry encoder

504

concatenating the one or more latent features with a plurality of parameters to obtain concatenated feature vector

506

obtaining a node feature vector by processing the concatenated feature vector using a node encoder

508

determining a relative position of edge end-vertices in the garment template and estimated garment deformation

510

encoding the determined relative position of edge end-vertices into an edge feature vector using an edge encoder

512

constructing an encoded garment graph using the node feature vector and edge feature vector

A

500

FIG. 5A

A

514

obtaining an updated encoded garment graph by iteratively performing a message passing algorithm on the encoded garment graph, wherein every node aggregates one or more features from associated one or more incident edges, wherein the aggregated one or more features are processed to update own features, and are broadcasted to one or more neighbouring nodes, and every edge node updates own features by taking the features from associated end nodes

516

determining the per-vertex displacement of the garment template by passing the updated garment graph through a displacement decoder

500

FIG. 5B

Body in
Canoni
cal pose

Body in
Target
pose

Template
Garment $\mathcal{G}$

Body motion aware ARAP
Garment Deformation

ARAP
deformed
garment

Geometry
Encoders

Geometry
Encoders

$\mathcal{F}^{gar}$

$\mathcal{F}^{body}$

Node
Feature
Encoders

Encoded
Garment
Graph

$\eta_i$ $\eta_j$

$\eta$

$\pi$

$\vec{u}\vec{v}$ $\vec{d}$ $\hat{n}$ $\mathcal{P}\mathcal{M}$

Edge
feature
encoder

$\mathcal{E}$ $\mathcal{E}^{ARAP}$

⬠ Aggregation operator

⊕ Concatenation operator

▥ MLP

h

L * message passing with updated node
and edge features$(\eta', \pi')$

$(\eta', \pi')$

$\eta_i$ $\eta_j$

$\pi_{ij}$

$\pi'_{ij}$

$\pi'_k$

$\bar{\pi}_k$

$\eta'_k$

$\eta'_k$

$\forall (k,j) \in F$

$N_{edge}$

$N_{node}$

$\pi_{ij}$

Message passing Graph Network Block

Displacement
decoder

$\delta$

Output:
Physically corrected

$\mathbb{G} + \delta$

FIG. 6

Garment (Skirt)

● Handle Garment Vertex

● Non-Handle Garment Vertex

● Closest Body Vertex

$$\tilde{\mathcal{G}}_i = \bar{\mathcal{G}}_i + \hat{d}_i(\|d_i\| - q_i)$$

$$q_i = \frac{\vec{d}_i \cdot \vec{u}_i}{\|d_i\|}$$

$\|d_i\| - q_i$

(a)          (b)

FIG. 7

$\hat{n}$    $\hat{D}$

Half-space

Garment mesh

Garment vertex

Closest body vertex

Body mesh

$\hat{n}$

$\hat{D}$

$\hat{b}$

(a)

(b)

FIG. 8

FIG. 9A

Template Outfit  GenSim  DeePSD  PBNS    GenSim  DeePSD  PBNS    Template Outfit  GenSim  DeePSD  PBNS

(a)    (b)    (c)    (d)    (e)    (f)    (g)    (h)    (i)    (j)    (k)

FIG. 9B

FIG. 10

FIG. 11

FIG. 12

Without pin and restrain loss    Without restrain loss

$\ell_{pe} + \ell_{ben} + \ell_{sm}$

$\ell_{pe} + \ell_{pin} + \ell_{ben} + \ell_{sm}$

$\ell_{pe} + \ell_{pin} + \ell_{str} + \ell_{ben} + \ell_{sm}$

*Ground Truth*

*Front*    *Back*       *Front*    *Back*       *Front*    *Back*       *Front*    *Back*

FIG. 13

0 ▮▮▮▮▮▮▮▮▮▮▮▮ 75mm

FIG. 14

FIG. 15

Europäisches
Patentamt

European
Patent Office

Office européen
des brevets

# EUROPEAN SEARCH REPORT

**Application Number**

EP 24 17 7195

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TIWARI LOKENDER ET AL: "GarSim: Particle Based Neural Garment Simulator", 2023 IEEE/CVF WINTER CONFERENCE ON APPLICATIONS OF COMPUTER VISION (WACV), IEEE, 2 January 2023 (2023-01-02), pages 4461-4470, XP034290796, DOI: 10.1109/WACV56688.2023.00445 [retrieved on 2023-02-06] * abstract * * section 3, 3.2, 3.2.1, 3.5 * * figures 1-3 * | 1-15 | INV. G06T13/40 G06T19/20 |
| X,P | TIWARI LOKENDER ET AL: "GenSim: Unsupervised Generic Garment Simulator", 2023 IEEE/CVF CONFERENCE ON COMPUTER VISION AND PATTERN RECOGNITION WORKSHOPS (CVPRW), IEEE, 17 June 2023 (2023-06-17), pages 4169-4178, XP034398155, DOI: 10.1109/CVPRW59228.2023.00439 [retrieved on 2023-08-15] * the whole document * | 1-15 | |

TECHNICAL FIELDS
SEARCHED        (IPC)

G06T

The present search report has been drawn up for all claims

| Place of search | Date of completion of the search | Examiner |
|---|---|---|
| Berlin | 12 September 2024 | Kröner, Sabine |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202321038154